(19) Europäisches Patentamt / European Patent Office / Office européen des brevets

(11) **EP 4 105 666 A1**

(12) **EUROPEAN PATENT APPLICATION**

(43) Date of publication:
**21.12.2022 Bulletin 2022/51**

(21) Application number: **21180013.1**

(22) Date of filing: **17.06.2021**

(51) International Patent Classification (IPC):
**G01R 15/24** (2006.01)

(52) Cooperative Patent Classification (CPC):
**G01R 15/245; G01R 15/246; G01R 15/247**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Hitachi Energy Switzerland AG**
**5400 Baden (CH)**

(72) Inventors:
- **GABUS, Philippe**
  **1260 Nyon (CH)**
- **ROCH. Jonas**
  **5430 Wettingen (CH)**
- **BONHERT, Klaus**
  **5452 Oberrohrdorf (CH)**

(74) Representative: **Epping - Hermann - Fischer Patentanwaltsgesellschaft mbH Schloßschmidstraße 5 80639 München (DE)**

(54) **POLARIZATION ANALYZER, MEASUREMENT ARRANGEMENT AND DETECTION METHOD**

(57) In at least one embodiment, the polarization analyzer (2) is configured for measuring a magneto-optic phase shift $\phi$ between two orthogonal polarization states of a signal radiation (SR) of a polarimetric fiber-optic current sensor (1), and comprises:
- a beam splitting module (24),
- a polarization processing module (25) optically downstream of the beam splitting module (24) comprising at least one linear polarizer (P, 42, 43) and at least one retarder (41, 44) with a temperature-dependent retardation variation m $\theta(T)$,
- a photo detector module (22) optically downstream of the beam splitting module (24), and
- a signal processing module (26) configured to calculate the magneto-optic phase shift $\phi$ from the electric signals (S1..S4) independent of the temperature-dependent retardation variation m $\theta(T)$.

Fig. 1

**Description**

A polarization analyzer, a measurement arrangement and a detection method are provided.

Fiber-optic current sensors, FOCS for short, for example, for use in high-voltage substations, commonly employ the Faraday effect in a coil of an optical fiber around a current conductor. High performance current sensors often use an interferometric technique as known from fiber gyroscopes to measure the Faraday effect. Here, a closed-loop detection circuit with an integrated-optic phase modulator recovers the current-induced magneto-optic phase shift $\phi$ between two light waves that propagate through the optical circuit.

FOCS with simpler polarimetric detection convert the magneto-optic phase shift by means of a quarter-wave plate and polarizer into a corresponding change of light intensity. The signal varies in proportion to the sine of the applied current. Frequently, the analyzer optics is configured to generate two signals of opposite phase. Their difference divided by the sum represents a normalized signal that is independent of light source power variations. For example, document EP 3 084 450 B1 describes a polarimetric FOCS with a fiber coil operated in reflection mode and analyzer optics consisting of a 1x3 - integrated-optic beam splitter, also referred to as PLC or Planar Lightwave Circuit splitter, supplemented with polarizers and a quarter-wave retarder.

Commercial polarization analyzers derive from usually four polarimetric signals the four so-called Stokes parameters, which characterize the state of polarization, SOP for short, and degree of polarization, DOP for short, of electromagnetic radiation. For example, document US 2020/0080845 A1 discloses a polarimetric fiber-optic gyroscope which utilizes a polarization analyzer to measure the rotation-induced Sagnac phase shift of two light waves counter-propagating in a coil of an optical fiber.

Document US 4 904 931 A refers to an electro-optical voltage measuring system incorporating a method and apparatus to derive the measured voltage waveform from two phase shifted electrical signals.

Embodiments of the disclosure relate to a simplified polarization analyzer and a measurement arrangement and a detection method using such a polarization analyzer.

The polarization analyzer, the measurement arrangement and the detection method are defined in the independent patent claims. Exemplary further developments constitute the subject-matter of the dependent claims.

Herein, the adaption of state-of the art polarization analyzers for use in FOCS is described. Moreover, a novel FOCS-specific inline analyzer concentric with the optical path is disclosed. The analyzer is significantly simpler than the state-of-the-art versions in that no complicated beam splitting is needed.

One possible setting of the analyzers' retarders and polarizers results in four polarimetric signals as follows:

Two signals are anti-phase signals proportional to the sine of the magneto-optic phase shift. Two further signals are anti-phase signals proportional to the cosine of the magneto-optic phase shift. For example, there is a half-wave retarder in one of the cosine-channels. In addition to the magneto-optic phase shift produced by the current, the signals can carry information on quasi-static phase shifts introduced by sensor components, the fringe contrast of the signals, and the temperature of the fiber coil. Appropriate signal processing separates the different contents. The separation significantly enhances the accuracy of DC measurement.

Polarimetric current sensors could utilize a polarization splitter adapted from a commercial 1x3 - integrated-optic PLC splitter to generate two polarimetric optical signals from which the current signal is derived. The necessary FOCS-specific splitter adaptations add cost and logistic complexity and limit the number of suitable suppliers.

As an alternative to an adapted PLC splitter, the present embodiments disclose the use of commercially available polarization analyzers in FOCS. Polarization analyzers characterize the polarization state of a light beam by measuring the four Stokes parameters of the polarization state. An adequate polarization analyzer with moderate adaptations can be readily spliced into the FOCS optical circuit.

Moreover, the embodiments disclose a novel splitter-free FOCS-specific inline polarization analyzer.

PLC splitters may generate two polarimetric optical signals for evaluation. By contrast, a full-scale polarization analyzer described herein generates at least three signals, for example, four signals. The two extra signals permit to correct for imperfections of FOCS components and changes in physical variables as a function of temperature. This enhances the sensor's accuracy, particularly in the case of direct current, DC, measurement. Commonly, polarimetric current sensors are unfit for DC.

The disclosure related to the embodiments outlines corresponding signal processing algorithms, both for the conventional configuration of the analyzer's retarder and polarizers and two alternative configurations more adequate for FOCS.

In particular, retarder - polarizer configurations and corresponding signal processing algorithms are disclosed for relatively small DC currents corresponding to magneto-optic phase shifts $\phi$ well within $\pm\pi/2$ as well as for extended current ranges with phase shifts beyond $\pm\pi/2$. For example, a phase shift of $\phi = \pi/2$ corresponds to a current of about 160 kA in case of one fiber loop and a wavelength of 1310 nm, or corresponds to a current of about 16 kA for 10 loops, respectively.

The signal processing algorithms described herein also deliver the temperatures of the analyzer and fiber coil for temperature compensation purposes.

In at least one embodiment, the polarization analyzer is configured for measuring a magneto-optic phase shift $\phi$ between two orthogonal polarization states of a signal radiation (SR) of a polarimetric fiber-optic current sensor, and comprises:

- a beam splitting module configured to receive a signal radiation and to split the signal radiation into at least three signal beam parts,
- a polarization processing module optically downstream of the beam splitting module comprising at least one linear polarizer and at least one retarder with a temperature-dependent retardation variation m $\theta(T)$, wherein m is a natural number greater than or equal to 1, and configured to process the at least three signal beam parts to having different intensities depending on the magneto-optic phase shift $\phi$ and on the temperature-dependent retardation variation m $\theta(T)$,
- a photo detector module optically downstream of the beam splitting module and having a plurality of detection areas, the detection areas are configured to detect the processed at least three signal beam parts and to produce electric signals representative for intensities of the at least three signal beam parts, and
- a signal processing module configured to calculate the magneto-optic phase shift $\phi$ from the electric signals independent of the temperature-dependent retardation variation m $\theta(T)$.

The term 'module' may mean that the respective device is a single component in which all sub-components are monolithically integrated. However, the term 'module' may also include that the module's components are present at least partially as separate components, for example, as separately mounted detection areas in case of the photo detector module or as separately applied polarizers in case of the polarization processing module.

The signals produced by the photo detector module can be electrical signals, either digital or analogue. Thus, the optical intensity of the signal beam part is translated into a corresponding electric signal. The detection areas could be arrays or pixels in a multi-channel detector, like a CCD, or could also be separate detectors like photo diodes.

According to at least one embodiment, for the retardation $\rho(T)$ of the at least one retarder it applies:

$$\rho(T) = \rho(T_0)[1 + \theta_T(T\text{-}T_0)]\text{with } \rho(T_0) = \mathrm{m}(\pi/2),$$

wherein $\theta_T = (1/\theta)(d\theta/dT)$ is the temperature coefficient of the retardation and $T_o$ is a reference temperature, for example, 20 °C. Odd numbers m correspond to quarter-wave retarders of different order, and even numbers m correspond to half-wave retarders.

The angle $\theta'(T) = m\theta(T) = m (\pi/2) \theta_T(T\text{-}T_0)$ corresponds to the temperature-dependent retardation variation of the at least one retarder from perfect m $\pi/2$-retardation. Correspondingly, the deviation in a zero-order quarter-wave retarder, that is, m = 1 and $\rho(T_0) = \pi/2$, is then $\theta(T)$, and the deviation in a zero-order half-wave retarder, that is, m = 2 and $\rho(T_0) = \pi$, is then $2\theta(T)$, assuming that both retarders are of the same material.

The retardation of a zero-order quartz retarder, for example, with $\theta_T = 1.014 \times 10^{-4}$ °C$^{-1}$ varies at a rate of - 0.913° / 100 °C. Herein, only a linear temperature coefficient of the retardation may be used, or otherwise also quadratic or cubic or further terms may be considered for the temperature coefficient of the retardation in order to increase accuracy.

According to at least one embodiment, the phase shift $\phi$ is a direct current, DC, phase shift or an alternating current, AC, phase shift or an AC phase shift combined with a DC offset. Thus, with the polarization analyzer described herein it is possible to measure DC currents, too.

According to at least one embodiment, the signals produced by the photo detector module comprise the following signals: $S_1 = S_o$, $S_2 = S_o$, $S_3 = (S_o/2)(1 + \cos \phi)$, $S_4 = (S_o/2)(1 + \sin \phi)$. Here, $S_o$ is in each case representative for an intensity of the respectively assigned signal beam part arriving at the polarization processing module from the beam splitting module.

According to at least one embodiment, the signals produced by the photo detector module comprise the following signals or consist of the following signals: $S_1 = (S_o/2)(1 + \cos \phi)$, $S_2 = (S_o/2)[1 - \cos (\phi + 2\theta)$, $S_3 = (S_o/2)[1 + \sin (\phi + \theta)]$, $S_4 = (S_o/2)[1 - \sin (\phi + \theta)]$. Herein, $\theta$, $2\theta$ are the temperature-dependent retardation variations of the at least one retarder used in a beam path in the polarization processing module at a given temperature.

According to at least one embodiment, the signals produced by the photo detector module comprise the following signals or consist of the following signals: $S_1 = (S_o/2) K (1 + \cos \phi)$, $S_2 = (S_o/2) K (1 - \cos \phi)$, $S_3 = (S_o/2) K [1 + \sin (\phi + \theta)]$, $S_4 = (S_o/2) K [1 - \sin (\phi + \theta)]$. Herein, $K$ is a fringe contrast factor, wherein $0 < K < 1$.

According to at least one embodiment, the polarization processing module comprises one or a plurality of quarter-wave retarders as the at least one retarder. The at least one quarter-wave retarder may exclusively be located in a beam path of the signal radiation so that a beam path of the forward radiation can be free of the at least one quarter-wave retarder. When arriving at the at least one quarter-wave retarder, the signal radiation has preferably already been split into the signal beam parts. Additionally or also alternatively to the at least one quarter-wave retarder, there can be one or a plurality of half-wave retarders or any mixture of at least one quarter-wave retarder and at least one half-wave retarder as the at least one retarder. If there is a plurality of retarders, all the retarders can be at the same angle, like 0° or at 90°, with respect to one of the two orthogonal polarization states of the signal radiation, or there are retarders at different angels with respect to one of the two orthogonal polarization states of the signal radiation.

According to at least one embodiment, the polarization processing module comprises one or a plurality of polarizers, in particular at least three polarizer, exemplarily four polarizers, at least one linear polarizer. Again, the at least one polarizer may exclusively be located in the beam path of the signal radiation so that the beam path of the forward radiation between the beam splitting module and the sensing fiber coil can be free of any polarizer. When arriving at the at least one polarizer, the signal radiation has preferably already been split into the signal beam parts. For example, the at least one polarizer is a linear polarizer.

According to at least one embodiment, the forward radiation runs through the beam splitting module. It is possible that the forward radiation is provided to the beam splitting module by means of a polarization-maintaining fiber. Said polarization-maintaining fiber may be provided with a polarizer, for example, a polarizer at +/- 45° with respect to one of the two orthogonal polarization states of the signal radiation.

According to at least one embodiment, the polarization processing module comprises:

- one or two or three quarter-wave retarders, for example, at 0° or at 90° with respect to one of the two orthogonal polarization states of the signal radiation, and/or
- one or two or three or four linear polarizers at +/- 45° with respect to said one of the two orthogonal polarization states of the signal radiation, and/or
- zero or one or two linear polarizers different from 45°, for example, at 0° or at 90°, with respect to said one of the two orthogonal polarization states of the signal radiation, and/or
- zero or one or two half-wave retarders, for example, at 0° or at 90° with respect to said one of the two orthogonal polarization states of the signal radiation.

Herein, at first approximation non-polarizing optical elements like beam splitters, polarizing maintaining fibers or lenses the polarization processing module may include are not listed.

According to at least one embodiment, the beam splitting module comprises a linear arrangement of at least three beam splitters. In this configuration it is possible that all beam splitters are arranged in a liner manner, that is, one behind the other along a path of the signal radiation.

According to at least one embodiment, the beam splitting module comprises an arrangement of at least three beam splitters, said at least three beam splitters are arranged in a geometrically non-linear manner. Hence, there is a branching of paths of the signal radiation and/or the signal beam parts in the beam splitting module and/or in the polarization processing module.

According to at least one embodiment, the signal processing module is configured to calculate the magneto-optic phase shift $\phi$ from the electric signals independent of the temperature-dependent retardation variation m $\theta(T)$. For example, a set of the above-mentioned equations $S_1 = (S_o/2) (1 + \cos \phi)$,

$$S_2 = (S_o/2) [1 - \cos (\phi + 2\theta),$$

$$S_3 = (S_o/2) [1 + \sin (\phi + \theta)],$$

$$S_4 = (S_o/2) [1 - \sin (\phi + \theta)],$$

or

$$S_1 = (S_o/2) \ K \ (1 + \cos \phi),$$

$$S_2 = (S_o/2) \ K \ (1 - \cos \phi),$$

$$S_3 = (S_o/2) \ K \ [1 + \sin (\phi + \theta)],$$

$$S_4 = (S_o/2) \; K \; [1 - \sin (\phi + \theta)]$$

is used for this purpose.

A polarimetric fiber-optic current sensor is additionally provided. The current sensor includes a polarization analyzer as indicated in connection with at least one of the above-stated embodiments. Features of the polarization analyzer are therefore also disclosed for the current sensor and vice versa.

According to at least one embodiment, the polarization analyzer and/or the polarimetric fiber-optic current sensor is configured to measure a current of at least 1 kA or of at least 10 kA. Alternatively or additionally, the current the polarization analyzer and/or the polarimetric fiber-optic current sensor is configured for at most 10 MA or at most 1 MA.

A measurement arrangement is additionally provided. The measurement arrangement includes a polarization analyzer as indicated in connection with at least one of the above-stated embodiments. Features of the polarization analyzer are therefore also disclosed for the measurement arrangement and vice versa.

In at least one embodiment, the measurement arrangement comprises a current sensor and a current conductor, wherein

- the current sensor comprises a light source to generate a forward radiation,
- the current sensor further comprises a polarization-maintaining fiber and a sensing fiber coil, the sensing fiber coil (40) comprising a fiber retarder and a sensing fiber, wherein one end of the polarization-maintaining fiber is connected with a signal beam input port of the polarization analyzer and the other end the polarization-maintaining fiber is connected to the fiber retarder of the sensing fiber coil, and
- the sensing fiber is coiled around a current conductor and the sensing fiber coil further comprises an end mirror at an end of the sensing fiber optically remote from the fiber retarder.

For example, the light source produces near infrared light, that is, radiation having a wavelength of maximum intensity of at least 780 nm and/or of at most 3 $\mu$m, for example, between 1000 nm and 1800 nm. The radiation may be incoherent radiation, provided by an LED, for example, or may be coherent radiation provided by a laser, like a laser diode. If polarized radiation is emitted by the light source, the light source needs to be aligned properly.

A method for using a polarization analyzer is additionally provided. By means of the method, preferably a polarization analyzer is used as indicated in connection with at least one of the above-stated embodiments. Features of the polarization analyzer are therefore also disclosed for the method and vice versa.

In at least one embodiment, the detection method using the polarization analyzer for measuring a magneto-optic phase shift $\phi$ between two orthogonal polarization states of a signal radiation of a polarimetric fiber-optic current sensor comprises:

- receiving, by the beam splitting module comprising the at least one linear polarizer and the at least one retarder with the temperature-dependent retardation variation m $\theta$(T), a signal radiation, and splitting, by the beam splitting module, the signal radiation into at least three signal beam parts,
- receiving, by the polarization processing module, the at least three signal beam parts, and processing, by the polarization processing module, the at least three signal beam parts so that at least three processed signal beam parts having different intensities depending on the magneto-optic phase shift $\phi$ and on the temperature-dependent retardation variation m $\theta$(T) are generated,
- receiving, by the photo detector module having the plurality of the detection areas, the at least three processed signal beam parts, and producing, by the photo detector module, electric signals representative for intensities of the at least three processed signal beam parts, and
- receiving, by the signal processing module, the electric signals from the photo detector module and calculating the magneto-optic phase shift $\phi$ from the electric signals so that a resulting magneto-optic phase shift $\phi$ is independent of the temperature-dependent retardation variation m $\theta$(T).

A polarization analyzer, a polarimetric fiber-optic current sensor, a measurement arrangement and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:

Figure 1          is a schematic block diagram of an exemplary embodiment of a polarization analyzer described herein,

Figure 2          is a schematic representation of a reference current sensor,

Figure 3          is a schematic representation of an exemplary embodiment of a polarimetric fiber-optic current sensor,

Figure 4          is a schematic representation of an exemplary embodiment of a polarization analyzer described herein,

Figure 5          is a schematic representation of a beam splitting module for polarization analyzers described herein,

Figures 6 to 8       are schematic representations of exemplary embodiments of polarization analyzers described herein,

Figure 9          is a schematic representation of a polarization processing module for polarization analyzers described herein,

Figures 10 and 11   are schematic representations of exemplary embodiments of polarization analyzers described herein, and

Figure 12         is a schematic representation of an exemplary embodiment of a method to use polarization analyzers described herein.

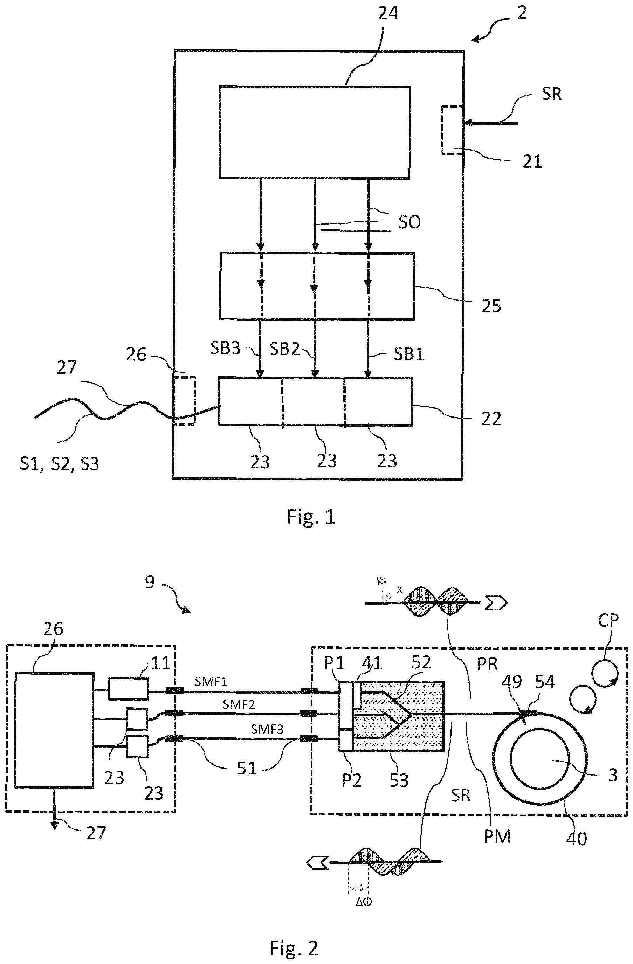

Figure 1 shows a polarization analyzer 2. The polarization analyzer 2 is configured to receive a signal radiation SR which is, for example, near infrared light of arbitrary polarization. The signal radiation SR typically arrives at the polarization analyzer 2 by means of an optical fiber but may alternatively arrive as a free beam, too. To receive the radiation SR, optionally there can be an input port 21.

Further, the polarization analyzer 2 comprises a beam splitting module 24. The beam splitting module 24 can comprise a plurality of beam splitters, like beam splitters based on prisms, metallic coatings and/or Bragg coatings. In the beam splitting module 24, the incoming signal radiation SR is split into a couple of beams or some beams are branched off the signal radiation SR. Within the splitting module 24, a polarization of the radiation is preferably not affected.

Signal beam parts resulting from the beam splitting module 24 may all be representative for an intensity of the received signal radiation SR; this is symbolized in Figure 1 by means of attributing all the signal beam parts an intensity of $S_0$, although the signal beam parts does not need to have the same intensity. For example, all the signal beam parts coming from the beam splitting module 24 have similar intensities proportional to an intensity of the signal radiation SR. For example, there are three signal beam parts.

The signal beam parts are then led to a polarization processing module 25. In the polarization processing module 25, the signal beam parts are processed so that processed signal beam parts SB1..SB3 result. For this purpose, the polarization processing module 25 may comprise any combination of polarizing affecting components like polarizers, quarter-wave retarders and/or half-wave retarders.

Then the processed signal beam parts SB1..SB3 arrive at a detector module 22. The detector module 22 comprises a plurality of detection areas 23. The detection areas 23 can be distinct, separate areas, like separate photo diodes, or the detection areas 23 are integrated in a single component and may be pixels or groups of pixels of a multi-channel diode or a charge coupled device, CCD for short, or the like.

In the detector module 22, for each one of the processed signal beam parts SB1..SB3 an electric signal S1..S3 is generated representative for intensities of the processed signal beam parts SB1..SB3.

Optionally, the polarization analyzer 2 could further comprise a signal processing module 26. In the signal processing module 26, the signals S1..S3 can be processed and may also be evaluated. Thus, the signal processing module 26 may provide data like an amperage. Hence, it is possible that the signals S1..S3 themselves may not leave the polarization analyzer 2.

Moreover, as a further option the polarization analyzer 2 may comprise an output line 27 by means of which the signals S1..S3 and/or data based on the signals S1..S3 are sent by the polarization analyzer 2 to an external entity, not shown. The output line 27 could be wire-based or could also be a radio signal or an optical signal. For example, by means of the output line 27 the signals S1..S3 and/or data are sent to an external computer or control unit. It is also possible that the output line 27 comprises or is a display, showing the signals S1..S3 and/or data, like the amperage.

Within the polarization analyzer 2, the respective beams can be guided by optical fibers or can be free beams or any mixture thereof. Although the different modules 21, 24, 25, 22, 26, 27 are schematically drawn as separate modules, it is also possible that some of the modules are combined with each other and/or that at least one of the modules is split into sub-modules. The same applies to all other exemplary embodiments.

In the following, some more specific examples are illustrated in more detail. For comparison, first a reference current sensor 9 is discussed.

Thus, Figure 2 shows a reference polarimetric fiber-optic current sensor 9. Light from a broad-band light source 11, for example, a superluminescent diode with a center wavelength of 1310 nm, is depolarized by a fiber Lyot depolarizer, not shown, and is transmitted via a single-mode optical fiber SMF1 to an integrated-optic 1x3 splitter 53, for example, a PLC splitter, having wave guides 52. At a source-side facet of the splitter 53, the light passes a polarizer P1 and a quarter-wave retarder 41, QWR for short. The light from the light source 11 is also referred to as forward radiation PR.

At a coil-side facet, the light couples into a polarization-maintaining fiber PM. The polarizer P1 is oriented at 45° to a principal axes of the polarization-maintaining fiber PM. Preferably, fiber axes are parallel and orthogonal to a normal of the splitter chip, for example, the polarizer P1 is aligned at 45° to the splitter normal. Principal retarder axes of a fiber retarder 54 are at 45° to the polarizer and parallel to the fiber axes. Hence, the retarder 41 introduces a phase delay of $(2n+1)\pi/2$ between the two orthogonal linearly polarized light waves that enter the polarization-maintaining fiber PM. Here, m is the order of the retarder, n = 0, 1, 2, ....; $n = 0$ is usually preferred.

A fiber-optic retarder 54 converts the orthogonal light waves into left and right circularly polarized waves CP before the light enters the sensing fiber 40. The sensing fiber 40 forms a coil with an integer number of fiber loops around a current conductor 3. The light reflects off a reflective coating, like an end mirror 49, at a far end of the sensing fiber 40 and then passes the coil a second time.

Upon reflection, the polarization states of the two light waves swap, that is, left circular light becomes right circular and vice versa. The fiber retarder 54 converts the reflected circular waves back to orthogonal linear waves. The latter waves' polarization directions are also swapped compared to the forward propagating waves. The returning orthogonal waves have a differential magneto-optic phase shift $\phi$ as a result of the Faraday effect.

The splitter 53 splits the returning light, also referred to as signal radiation SR, into two detection channels. The orthogonal waves of each channel interfere at a polarizer, that is, polarizers P1 and P2, respectively. The polarizers P1, P2 are at +45° and -45° to the splitter normal. Polarizer P1 is common to the light source channel and detector channel 1. Two further single mode fibers SMF2, SMF3 guide the light transmitted through the polarizers to the two photo detectors 23. To connect the single mode fibers SMF1, SMF2, SMF3, there can be fiber connectors 51.

Under ideal conditions, the two detector signals from the photo detectors 23 are given as

$$S_1 = (S_o/2)\ [1 + \sin \phi] \qquad (1)$$

$$S_2 = (S_o/2)\ (1 - \sin \phi] \qquad (2)$$

The magneto-optic phase shift f is given as

$$\phi = 4NVI \qquad (3)$$

N, V, I are the number of windings of the fiber coil 40, the Verdet constant of the sensing fiber 40 which is about 1.0 $\mu$rad/A at 1310 nm for fused silica fiber, and the current, respectively. $S_o$ is proportional to the light source power. The difference of the two signals divided by their sum results in a signal S independent of the light source power:

$$S = \sin \phi \qquad (4)$$

The following describes a polarimetric fiber-optic current sensor 1, FOCS for short, with a polarization analyzer 2 for interrogation. Here, the term polarization analyzer 2 stands for a device that derives four polarimetric signals from an incoming light beam SR, from which typically the Stokes parameters of the light's polarization state are derived. By contrast, polarimetric current sensors like in Figure 2 only work with two polarimetric signals.

The extra signals permit to correct for imperfections of sensor components and changes in physical variables as a function of temperature and thus help to enhance the sensor's accuracy, particularly in case of direct current, DC, measurement.

Herein, it is described how the polarization analyzers 2 are operated in an FOCS 1. Besides two known analyzer configurations, a novel and FOCS specific analyzer set-up is disclosed. Furthermore, signal processing methods based on both the conventional retarder and polarizer settings of an analyzer and retarder/polarizer combinations more adequate for FOCS are disclosed.

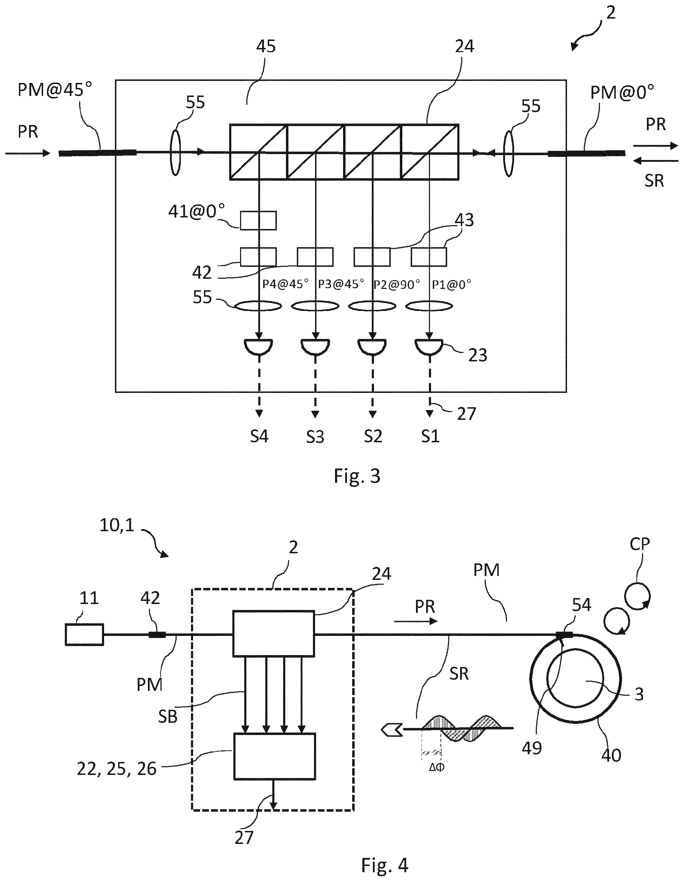

Figure 4 schematically illustrates the configuration of a polarimetric current sensor 1 in a measurement arrangement 10 of the present disclosure. A, for example, commercially available inline polarization analyzer 2 replaces the integrated-optic polarization splitter of Figure 2. In standard analyzer mode, the light to be analyzed enters the analyzer 2 through the right-hand side fiber pigtail. The analyzer 2 utilizes fractions of the input light SR for polarization analyses. The remainder input light SR leaves the analyzer 2 through the left-hand side pigtail for application-specific use, for example.

For use in the current sensor 1, the pigtails are from a polarization-maintaining fiber PM, and the fiber coil 40 is spliced to the right-hand side pigtail, that is, the analyzer's 2 standard input end. The source light PR enters the analyzer 2 from the left-hand side, that is, an output end in standard mode, and travels through the analyzer 2 to the fiber coil 40. A fiber polarizer 42 or a polarizing fiber polarizes the initially depolarized source light PR before the analyzer 2. The polarizer 42 is oriented at 45° to a principal axis of the coil-side polarization-maintaining fiber PM, so that both orthogonal polarization modes of that polarization-maintaining fiber PM are excited with equal amplitude.

Further, Figure 3 shows details of the polarization analyzer 2 used, for example, in the measurement arrangement 10 of Figure 4. Four serially arranged beam splitters 45 send fractions of the light SR returning from the fiber coil 40 through four polarizers P1..P4 of the polarization processing module 25 to four corresponding photodetectors 23 of the detector module 22. A principal axis of the coil-side fiber PM is perpendicular to the plane of incidence of the beam splitters 45.

The polarizers Pi, i = 1 to 4, of the four analyzer channels are oriented at 0°, 90°, 45°, and 45°, respectively, with respect to an axis of the coil-side polarization-maintaining fiber PM. The fourth channel includes a quarter-wave retarder 41 with a principal axis at 0°, that is, the retarder/analyzer combination in that channel represent a circular polarizer. The four detector signals are given as follows:

$$S_1 = S_o \qquad (5)$$

$$S_2 = S_o \qquad (6)$$

$$S_3 = (S_o/2) \ (1 + \cos \phi) \quad (7)$$

$$S_4 = (S_o/2) \ (1 + \sin \phi) \quad (8)$$

Equations (5) - (8) assume ideal conditions: the optical powers in the four channels are identical and the beam splitters 45 are ideal, that is, the splitters 45 reflect p and s polarization components with equal amplitude and do not introduce a differential phase shift between them. In practice, the power levels in the four channels are normalized to equal amplitude by calibration. Unequal reflection coefficients for p and s polarizations result in a fringe contrast less than unity, while a differential phase shift at the splitters shows up as an extra phase term in Equations (7), (8).

Dividing signals $S_3$ and $S_4$ by signal $S_1$ or $S_2$ makes the two signals independent of the source power, represented by $S_0$. As $S_3$ and $S_4$ are at quadrature, that is, 90° out of phase), the magneto-optic phase shift $\phi$ and, hence, the current $I$ can be unambiguously derived from the two signals over arbitrary ranges of $\phi$. This is particularly of interest to the measurement of high DC. Corresponding currents may reach hundreds of kiloamperes and produce phase shifts well outside the range of $\pm \pi/2$ covered by the reference sensor 9 of Figure 2. The demodulation of quadrature signals is widely known, for example, from encoders and optical voltage sensors, compare document US 4 904 931 A.

For practical reasons, it is advantageous, if all splitters 45 have the same splitting ratio, for example, a ratio of 1:20, that is, the splitters 45 reflect 5 % of the light SR. This ascertains relatively low optical loss on the path from the light source 11 to the fiber coil 40 and results in similar power levels at the four detectors 23. For example, a reflectivity of the splitters 45 is at least 1% and/or is at most 10% or at most 6%. The same applies to all other exemplary embodiments, too.

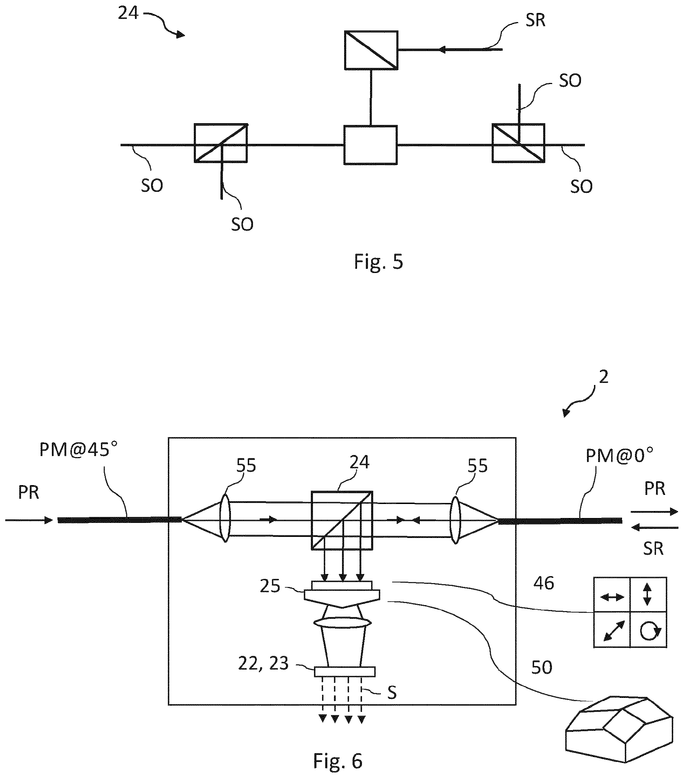

It is obvious to a person skilled in the art that splitter arrangements other than the serial arrangement of Figure 3 are possible. In particular, the source light may only pass through one splitter 45 on the way to the coil 40, while the other three splitters 45 reside in an orthogonal or branched light path away from that splitter 45. Such an arrangement makes more efficient use of the available optical power. Another exemplary arrangement having only one splitter 45 in the main beam path is illustrated in Figure 5 wherein the splitters 45 are arranged in a T-shaped manner resulting in three bifurcations.

A polarization analyzer 2 with polarizer orientations as in Figure 3 fully characterizes the polarization state of a light beam by determining the four Stokes parameters. The situation in the FOCS 1 is simpler in that the chosen polarization-maintaining fiber orientations pre-determine the axes of the polarization ellipse, as a result of which the signal $S_2$ is redundant. Alternative polarizer orientations, more adequate for FOCS 1, and corresponding signal processing options will be considered further below. At first, the following presents further analyzer configurations adapted to the FOCS 1.

Otherwise, the same as to Figures 1 and 2 may also apply to Figures 3 to 5, and vice versa.

The analyser 2 of Figure 6 utilizes a polarization analyzer as disclosed in document US 7 372 568 B1. A quadrant polarizer 46 and a quadrant prism 50 as well as a subsequent lens 55 disperse the light SR returning from the fiber coil 40 onto the four sectors of a quadrant detector 22. Polarizers with appropriate orientations are configured in the four quadrants, either in front of the prism as shown, or in front of the individual detectors 23.

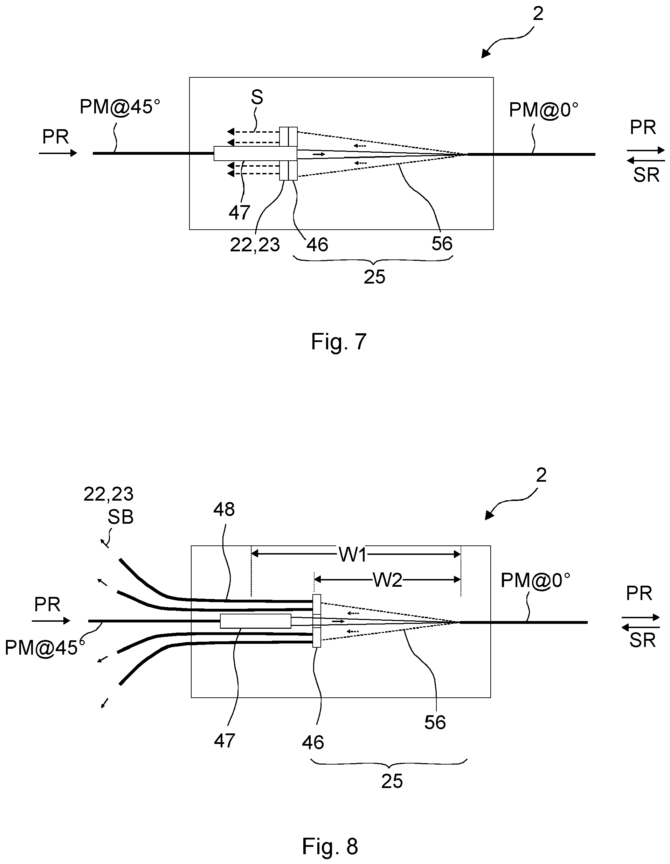

Figure 7 shows another inline version of a quadrant polarization analyser 2. A graded index lens 47, GRIN lens for short, after the fiber polarizer focuses the source light PR into the polarization-maintaining fiber link of the fiber coil 40. The light SR returning from the coil 40 falls on an inline quadrant detector array 22 with a central opening for the GRIN lens 47, or for the forward light beam PR if the array resides between the lens and the polarization-maintaining fiber link of the coil.

Quadrant polarizers 46 are again configured in front of the detector array 22, 23. For better use of the returning light SR, more than four detectors 23 may be used, for example, eight detectors. Each polarizer then may cover two of the detectors. Alternatively, the quadrant detector 22 may be configured as a ring with four 90°-detector-segments, packaged in a common casing. As a further alternative, each detector 23 may be packaged in its own casing. Other than the set-up of Figure 4, the arrangement of Figure 7 does not require a wedge prism or lens and, thus, can avoid optical loss at beam splitters.

In Figure 8, four large-core optical fibers 48 with their end facets arranged in a ring concentric with the optical axis collect the light SR returning from the coil 40 and transmit the light to remote detectors 22, 23. This arrangement permits to operate the analyzer 2 at locations to which electric detector connections are not possible, such as on high voltage. Again, the fiber bundle may contain numerous fibers for efficient light collection. Large core fibers 48 are available with diameters of a fiber core 61, for example, of at least 50 $\mu$m and/or of at most 2 mm, like 200 $\mu$m, 400 $\mu$m, 600 $\mu$m, or 800 $\mu$m. A cladding diameter of a fiber cladding 62 typically exceeds the core diameter by at least 2% and/or by at most 40%, for example, by 10 %.

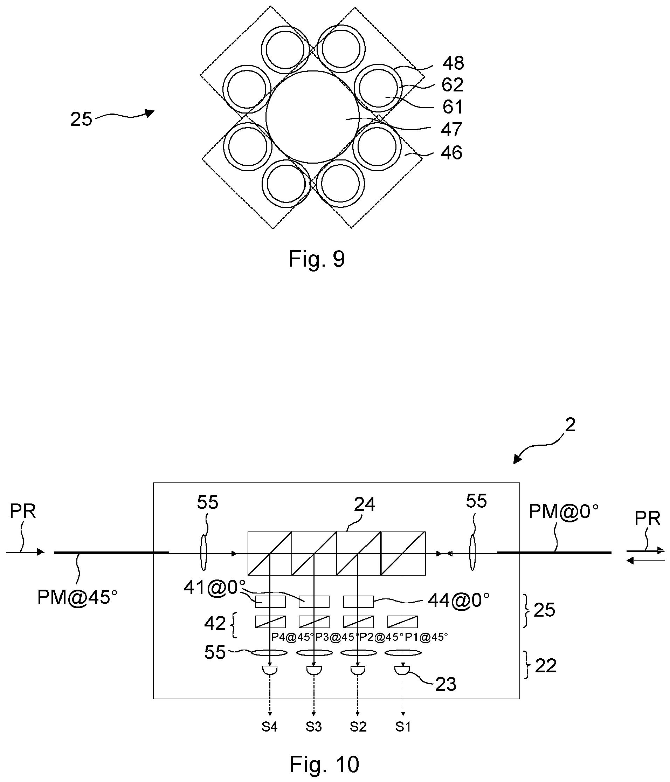

GRIN lens rods are available in various diameters, for example, of at least 0.2 mm and/or of at most 5 mm, like 0.5 mm, 1 mm, 1.8 mm, or 2 mm. If the lens 47 has a diameter of 1.8 mm and the large core fiber 48 of 0.88 mm, corresponding to a 800 $\mu$m-core 61; eight fibers 48 with slight spare space in between them can be arranged around the lens and in direct contact with the lens, as schematically shown in Figure 9. The outer diameter of the fiber bundle is then 3.56 mm, for example. A proper gap width w1 between the two polarization-maintaining fibers PM depends on the specifications of the GRIN lens 47 and may correspond to at least 5 mm and/or to at most 10 cm, for example, to 25 mm.

Assuming that the light cone at the facets of the fiber bundle should have the same diameter as the bundle, and further assuming that the coil side polarization-maintaining fiber PM has a usual numerical aperture, NA, of, for example, 0.12, an on-axis distance w2 between the bundle facets and the fiber PM should be, for example, 14.7 mm. The distance reduces to 9.6 mm for a polarization-maintaining fiber PM with NA = 0.18. Preferably, w2 is chosen somewhat larger, so that light closer to the cone center, where the light intensity is higher, reaches the fiber bundle and/or the detectors 23. The fiber bundle may be composed of several concentric fiber layers, particularly in cases of fibers with smaller core diameter, such as 200 $\mu$m.

Of course, the inline analyzer can also be configured with only two detectors and corresponding retarders and polarizers such that the analyzer generates the same two signals as the 1x3 polarization splitter of Figure 2. Again, a fiber bundle may be used to efficiently collect the light. The same applies to all other exemplary embodiments.

Otherwise, the same as to Figures 1 to 6 may also apply to Figures 7 to 9, and vice versa.

The exemplary retarder and polarizer configurations of Figure 3 may not be the most adequate one for the FOCS 1, since signal S2 is redundant and signals S1 and/or S2 are only used as power reference. Other settings permit to correct for non-ideal sensor components and influences of temperature. An exemplary set of polarizer and retarder settings is shown in Figure 10. The settings are shown for the polarization analyzer 2 of Figure 3, but apply equally to the other analyzer configurations as well.

The settings of Figure 10 are especially of interest to the measurement of DC with magneto-optic phase shifts $\phi \ll 1$. A phase shift of 0.1 rad, for instance, approximately corresponds to a current of 25 kA for a coil with one fiber loop and a wavelength of 1310 nm.

A problem in DC current measurement with polarimetric sensors is that optical phase changes, for example, as a result of the temperature dependence of the analyzer's quarter-wave retarder, cannot be distinguished from magneto-optic phase changes $\phi$. This can result in severe uncertainty in the measured current of up to several kiloamperes. The configuration of Figure 10 allows one to separate thermal and magneto-optic phase shifts.

First, assumed are ideal beam splitters 45 and an ideal fiber coil 40, that is, a sensing fiber free of linear birefringence, and a fiber quarter-wave retarder with perfect $\pi/2$-retardation. The signals $S_i$ are then given as follows:

$$S_1 = (S_o/2) (1 + \cos \phi) \qquad (9)$$

$$S_2 = (S_o/2) [1 - \cos (\phi + 2\theta)] \qquad (10)$$

$$S_3 = (S_o/2) [1 + \sin (\phi + \theta)] \qquad (11)$$

$$S_4 = (S_o/2) [1 - \sin (\phi + \theta)] \qquad (12)$$

The angle $\theta = \theta(T)$ is the temperature-dependent deviation of the quarter-wave retarders in detector channels 3 and 4 from perfect $\pi/2$-retardation and for quarter-wave retarders of zero order. Note that the deviation is then $2\theta$ for the half-wave retarder in channel 2, assuming that both retarders are of the same material and of zero order. $\theta(T)$ is given as $\theta(T) = \rho(T_0) \theta_T (T-T_0)$. Here, $\rho(T_0) = \pi/2$ is the retardation at a reference temperature $T_0$, for example, at 20 °C, and $\theta_T = (1/\theta) (d\theta/dT)$ is the temperature coefficient of the retardation. The retardation of a zero-order quartz retarder, for example, with $\theta_T = 1.014 \times 10^{-4}°C^{-1}$ varies at a rate of - 0.913° / 100°C. The overall temperature-dependent retardation $\rho(T)$ is thus $\rho(T) = \rho(T_0) [1 + \theta_T(T-T_0)]$.

The difference of signals $S_3$, $S_4$ divided by their sum gives a signal $S'$ as follows:

$$S' = \sin (\phi + \theta) \qquad (13)$$

For sufficiently small $\phi$ and $\theta(\phi, \theta \ll 1)$, $S'$ becomes

$$S' = \phi + \theta \qquad (14)$$

Apparently, from the signal $S'$ alone, a DC current-induced change in $\phi$ cannot be distinguished from a temperature-induced change in $\theta$. A change in $\theta$ by 0.5°, corresponding to a temperature excursion of 55 °C, corresponds to a current of 4360 A for a coil with one fiber loop and a wavelength of 1310 nm, or corresponds to a current of 436 A for 10 loops.

In order to separate the individual values of $\phi$ and $\theta$, the difference of $S_1$ and $S_2$ is calculated and is divided by the sum of $S_3$ and $S_4$ and thus a signal $S''$ is obtained as:

$$S'' = (1/2) [\cos\phi + \cos (\phi + 2\theta)] \qquad (15)$$

or

$$S'' = (1/2) [\cos\phi + \cos\phi \cos(2\theta) - \sin\phi \sin(2\theta)] \qquad (16)$$

Again assuming sufficiently small $\phi$ and $\theta$, Equation (16) can be expanded as follows:

$$S'' = 1 - \phi^2/2 - \theta^2 - \phi\theta \qquad (17)$$

The phase shifts of interest, that is, $\phi$ and $\theta$, can now unambiguously be extracted from Equations (14) and (17).
One should note that the quadratic and mixed terms of $\phi$ and $\theta$ in Equation (17) are relatively small and their recovery is limited by noise. Typically, the noise in the normalized signals $S_i$ is, for example, on the order of $10^{-7} /\sqrt{Hz}$. The resolution of $\theta$ is given by the square root of this number and corresponds to about $3 \times 10^{-4} \ rad/\sqrt{Hz}$. Since $\theta$ varies only slowly with time, the resolution can be improved by appropriate time-averaging of $S_1$ and $S_2$. As an option, an averaging time is at least 10 s and/or is at most 600 s or at most 200 s. For example, an averaging time of 100 s may improve the resolution by a factor of ten to $3 \times 10^{-5}$ rad. This leaves an uncertainty in the measured current of 30 A for a fiber coil with one winding, or 3 A for 10 windings, again at a wavelength of 1310 nm. Hence, the method reduces the measurement error by more than two orders of magnitude.

Phase shifts introduced by non-ideal beam splitters add to the arguments of the sine and cosine functions of Equations (9) to (12) in the same manner as the retarder phase shifts $\theta$ and are then included in $\theta$.

The phase shift $\theta(T)$ can be calibrated in terms of the ambient temperature. The knowledge of the temperature allows one to compensate for other temperature dependent contributions, particularly contributions of the fiber coil in case the coil is not self-compensating or only partially compensating.

In equations (9) to (12), the fringe contrast $K$ has been assumed as unity. An imperfect 45°-orientation of the source-side fiber polarizer with respect to the principal axes of the polarization-maintaining fiber link of the fiber coil and different reflection coefficients for p and s polarized light at the beam splitters result in a fringe contrast $K$ less than unity. $K$ then appears in Equations (9) to (12) as an additional factor in front of the sine and cosine terms. In this case, all three variables, $K$, $\phi$, and $\theta$ can be extracted from the equations. $K$ essentially remains constant, though, and $K < 1$ can be accounted for by calibration.

Large DC currents with magneto-optic phase shifts beyond $\pm\pi/2$ can again be derived from signal pairs at quadrature, for example, from the pairs $S_1$, $S_3$ or $S_2$, $S_3$. The phase $\theta(T)$ and, thus, the analyzer temperature can be extracted, if both signal pairs are evaluated together, since $\theta(T)$ affects them differently.

The Verdet constant $V$ varies a function of temperature at a rate of $0.7 \times 10^{-4}$ °C$^{-1}$. For example, over a temperature range of 100°C, the Verdet constant of fused silica fibers and, hence, the current signal change by 0.7 %. Moreover, variations with temperature in the retardation $\rho$ of the fiber retarder at the coil entrance, see Figure 2, also affect the sensor's scale factor. It is known that by detuning the fiber retarder by an appropriate amount $\varepsilon$ from perfect $\pi/2$-retardation, the two contributions cancel each other to first order and the sensor signal becomes essentially independent of temperature. The proper value of $\varepsilon$ depends on the type of the sensing fiber, that is, if a low birefringence fiber or a spun birefringent fiber is used, and on the bend-induced fiber birefringence, and on the temperature coefficient of the fiber retarder. As an example, the case of a low-birefringent sensing fiber with negligible bend-induced birefringence is considered. The four detector signals can then be derived by describing the light propagation through the optical circuit by means of Jones matrices and are now given as follows:

$$S_1 = (S_o/2)\ (1 + \cos^2\varepsilon)\ \cos^2(\phi/2) \qquad (18)$$

$$S_2 = S_o/2)\ (1 + \cos^2\varepsilon)\ \sin^2(\phi/2 + \theta) \qquad (19)$$

$$S_3 = (S_o/2)\ [1 + \cos\varepsilon\ \sin\ (\phi + \theta)] \qquad (20)$$

$$S_4 = (S_o/2)\ [1 - \cos\varepsilon\ \sin\ (\phi + \theta)] \qquad (21)$$

First, the case of alternating currents is considered. The magneto-optic phase shift is then given as $\phi(t) = \phi \sin(\omega t)$, wherein $\omega$ is the circular frequency of the current and $t$ is the time. The difference of the signals $S_3$, $S_4$ divided by their sum gives for $\phi(t) \ll 1$:

$$S = \cos\varepsilon\ (\phi(t) + \theta) \qquad (22)$$

The alternating term of interest, $(\cos\varepsilon)\ \phi(t)$, is separated from the quasi-static term, $(\cos\varepsilon)\ \theta$, by filtering. Note, that the term $(\cos\varepsilon)\ \phi(t)$ is independent of temperature; the term $\cos\varepsilon$ varies to first order linearly with temperature and cancels the temperature dependence of $\phi$. The term $\cos\varepsilon\ \theta$ can be used as a measure for the ambient temperature.

Furthermore, from Equation (18) by filtering out the alternating term and after power normalization a signal $S_1$' is obtained given as:

$$S_1' = (1 + \cos^2\varepsilon) \qquad (22')$$

The angle $\varepsilon$ can be determined from $S_1$' and thus the temperature of the fiber coil. The coil temperature can be used to compensate for any residual temperature dependence of partially compensated coils. With $\varepsilon$ known, one can then analogously extract the angle $\theta$ from any of the other three equations which gives the temperature at the analyzer location. The knowledge of the analyzer and coil temperatures allows one to independently temperature-compensate the two components without the need of extra temperature sensors. This is of interest, for example, in cases where the two components are exposed to different ambient temperatures. Note that further compensation of the coil may only be necessary should the fiber retarder under-compensate or overcompensate the coil due to fabrication tolerances; that is tolerances in $\varepsilon$.

In case of DC, one can make use of the fact that Equations (18) to (20) represent three independent equations with three unknown variables to separate $\phi$, $\theta$, and $\varepsilon$, similarly as described further above.

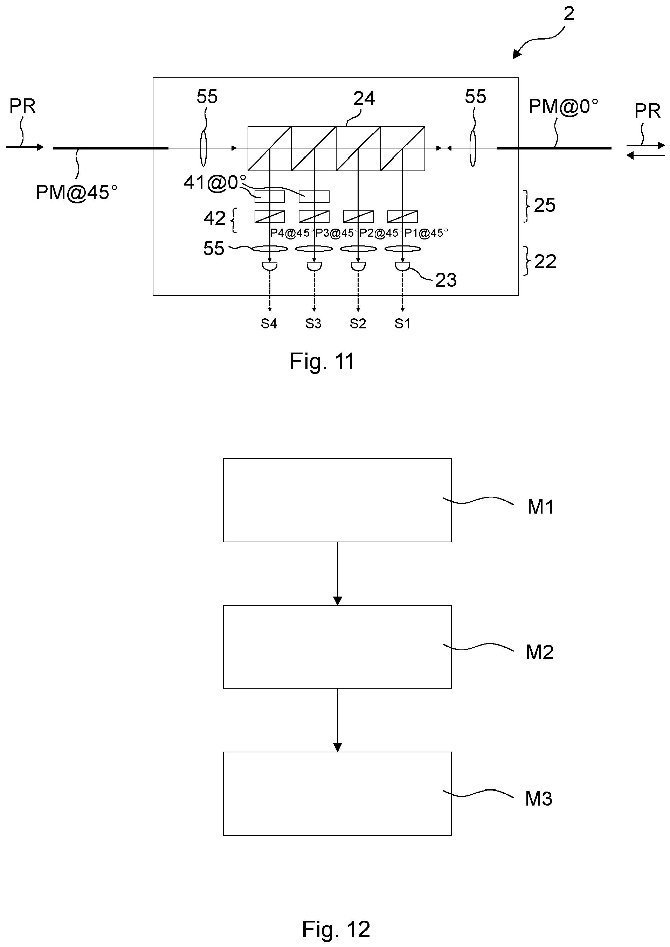

For completeness, Figure 11 shows an analyser configuration which is the same as in Figure 10, but without the half-wave retarder in detector channel 2. Here, we consider the case of a non-perfect fringe contrast, that is, $K < 1$. The fiber retarder at the coil is assumed as a perfect $\pi/2$-retarder, that is, the coil is not temperature-compensated. The four signals are then given as follows:

$$S_1 = (S_o/2) \; K \; (1 + \cos \phi) \qquad (23)$$

$$S_2 = (S_o/2) \; K \; (1 - \cos \;) \qquad (24)$$

$$S_3 = (S_o/2) \; K \; [1 + \sin (\phi + \theta)] \qquad (25)$$

$$S_4 = (S_o/2) \; K \; [1 - \sin (\phi + \theta)] \qquad (26)$$

This case is mainly of interest for alternating current, AC, measurement. The current signal is extracted from Equations (25) and (26) as described further above. Assuming small $\phi(t)$, the alternating components is then given as:

$$S' = K \; \phi(t) \qquad (27)$$

The difference of signals $S_1$, $S_2$ divided by their sum gives:

$$S'' = K \; \cos\phi(t) \qquad (23)$$

Low pass filtering of Equation (23) yields the contrast $K$, which can be used to correct for any variations of $K$ in the signal $S'$ if necessary.

Otherwise, the same as to Figures 1 to 9 may also apply to Figures 10 and 11, and vice versa.

In Figure 12, the method to use the polarization analyzer 2 in the FOCS 1 as specified above.

In method step M1, the beam splitting module 24 receives the signal radiation SR from the coil 40 and splits the signal radiation SR into the at least three signal beam parts SB1..SB4.

In method step M2, the polarization processing module 25 receives the at least three signal beam parts from the beam splitting module 24 and processes the at least three signal beam parts so that the at least three processed signal beam parts SB1..SB4 having different polarizations result.

In method step M3, the photo detector module 22 receives the at least three processed signal beam parts SB1..SB4 from the beam splitting module 24 and produces the signals S1..S4 representative for intensities of the at least three processed signal beam parts SB1..SB4.

Further method steps, like producing the forward radiation, sending the radiation through the coil 40, and polarizing the radiation before reaching the polarization analyzer, are not illustrated in Figure 12 for simplicity.

Otherwise, the same as to Figures 1 to 11 may also apply to Figure 12, and vice versa.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

List of Reference Signs

| | |
|---|---|
| 1 | current sensor |
| 10 | measurement arrangement |
| 11 | light source |
| 2 | polarization analyzer |
| 21 | input port |
| 22 | detector module |
| 23 | detection area |
| 24 | beam splitting module |
| 25 | polarization processing module |
| 26 | signal processing module |
| 27 | output line |
| 3 | current conductor |
| 40 | sensing fiber coil |
| 41 | quarter-wave retarder |
| 42 | polarizer at +/- 45° |
| 43 | polarizer not at +/- 45° |
| 44 | half-wave retarder |
| 45 | beam splitter |
| 46 | quadrant polarizer |
| 47 | graded index lens |
| 48 | large-core fibers |
| 49 | end mirror |
| 50 | quadrant prism |
| 51 | fiber connector |
| 52 | waveguide |
| 53 | splitter |
| 54 | fiber retarder |
| 55 | lens |
| 56 | light beam cones |
| 61 | fiber core |
| 62 | fiber cladding |
| 9 | reference current sensor |
| CP | circularly polarized light waves |
| IM | electric current |
| M.. | method step |
| P.. | polarizer |
| PM | polarization-maintaining fiber |
| PR | forward radiation |
| SR | signal radiation |
| S.. | signal |
| SB.. | processed signal beam part |
| SMF | single mode fiber |
| w1 | gap width |
| w2 | on-axis distance |

**Claims**

1.  A polarization analyzer (2) for measuring a magneto-optic phase shift ϕ between two orthogonal polarization states of a signal radiation (SR) of a polarimetric fiber-optic current sensor (1), comprising:

    - a beam splitting module (24) configured to receive the signal radiation (SR) and to split the signal radiation (SR) into at least three signal beam parts,
    - a polarization processing module (25) optically downstream of the beam splitting module (24) comprising at least one linear polarizer (P, 42, 43) and at least one retarder (41, 44) with a temperature-dependent retardation variation m $\theta$(T), m is a natural number equal to or larger than 1, and configured to process the at least three signal beam parts to get at least three processed signal beam parts (SB1..SB4) having different intensities depending on the magneto-optic phase shift $\phi$ and on the temperature-dependent retardation variation m $\theta$(T),
- a photo detector module (22) optically downstream of the beam splitting module (24) and having a plurality of detection areas (23), the detection areas (23) are configured to detect the at least three processed signal beam parts (SB1..SB4) and to produce electric signals (S1..S4) representative for intensities of the at least three processed signal beam parts (SB1..SB4), and
- a signal processing module (26) configured to calculate the magneto-optic phase shift $\phi$ from the electric signals (S1..S4) independent of the temperature-dependent retardation variation m $\theta$(T).

2. The polarization analyzer (2) according to the preceding claim,
wherein there are exactly four of the signal beam parts (SB1..SB4) and exactly four corresponding signals (S1..S4).

3. The polarization analyzer (2) according to any one of the preceding claims,
wherein the phase shift $\phi$ is a direct current, DC, phase shift, or an alternating current, AC, phase shift with a DC offset.

4. The polarization analyzer (2) according to claim 1 or 2, wherein the polarization processing module (25) comprises at least three of the linear polarizers (P, 42, 43),
wherein for the temperature-dependent retardation $\rho$(T) at a temperature T it applies: $\rho(T) = m [(\pi/2 + \pi/2\ \theta_T(T-T_0)]$, wherein $T_0$ is a reference temperature, and $\theta_T = (1/\theta)\ (d\theta/dT)$ is the temperature coefficient of the temperature-dependent retardation.

5. The polarization analyzer (2) according to any one of the preceding claims,
wherein the signals (S1..S4) comprise the following signals:

$$S_1 = (S_o/2)\ (1 + \cos\ \phi)$$

$$S_2 = (S_o/2)\ [1 - \cos\ (\phi + 2\theta)$$

$$S_3 = (S_o/2)\ [1 + \sin\ (\phi + \theta)]$$

$$S_4 = (S_o/2)\ [1 - \sin\ (\phi + \theta)],$$

wherein $S_o$ is in each case representative for an intensity of the respectively assigned signal beam part (SB1..SB4) arriving at the polarization processing module (25) from the beam splitting module (24), and $\theta, 2\theta$ are temperature-dependent retardation variations at a given temperature of the at least one retarder (41, 44) used in a beam path in the polarization processing module (25).

6. The polarization analyzer (2) according to any one of claims 1 to 4,
wherein the signals (S1..S4) comprise the following signals:

$$S_1 = (S_o/2)\ K\ (1 + \cos\ \phi)$$

$$S_2 = (S_o/2)\ K\ (1 - \cos\ \phi)$$

$$S_3 = (S_o/2)\ K\ [1 + \sin\ (\phi + \theta)]$$

$$S_4 = (S_o/2)\ K\ [1 - \sin\ (\phi + \theta)],$$

wherein $S_o$ is in each case representative for an intensity of the respectively assigned signal beam part (SB1..SB4) arriving at the polarization processing module (25) from the beam splitting module (24), θ is the temperature-dependent retardation variation at a given temperature of the at least one retarder (41, 44) used in a beam path in the polarization processing module (25), and $K$ is a fringe contrast factor, $0 < K < 1$.

7. The polarization analyzer (2) according to any one of the preceding claims,
   wherein, as the at least one retarder (41, 44), the polarization processing module (25) comprises two quarter-wave retarders (41) and one half-wave retarder (44) at 0° with respect to one of the two orthogonal polarization states of the signal radiation (SR) and, as the at least one linear polarizer (P, 42, 43), further comprises four polarizers (42) at +/- 45° with respect to the one of the two orthogonal polarization states of the signal radiation (SR).

8. The polarization analyzer (2) according to any one of claims 1 to 6,
   wherein, as the at least one retarder (41, 44), the polarization processing module (25) comprises two quarter-wave retarders (41) at 0° with respect to one of the two orthogonal polarization states of the signal radiation (SR) and, as the at least one linear polarizer (P, 42, 43), further comprises four polarizers (42) at +/- 45° with respect to the one of the two orthogonal polarization states of the signal radiation (SR), and
   wherein the polarization processing module (25) is free of any half-wave retarder.

9. The polarization analyzer (2) according to any one of the preceding claims,
   wherein the beam splitting module (24) comprises a linear arrangement of at least three beam splitters (45).

10. The polarization analyzer (2) according to any one of the preceding claims,
    wherein the beam splitting module (24) comprises an arrangement of at least three beam splitters (45), said at least three beam splitters (45) are arranged in an geometrically non-linear manner.

11. The polarization analyzer (2) according to any one of the preceding claims,
    wherein the polarization processing module (25) comprises a quadrant polarizer (46), and
    wherein the detector module (22) comprises a quadrant detector.

12. The polarization analyzer (2) according to any one of the preceding claims,
    wherein the beam splitting module (24) comprises a graded index lens (47) around which the polarization processing module (25) and the detector module (22) are arranged.

13. The polarization analyzer (2) according to any one of the preceding claims,
    comprising a plurality of large-core fibers (48) arranged between the polarization processing module (25) and the detector module (22).

14. A measurement arrangement (10) comprising a current sensor (1) and a current conductor (3), wherein

    - the current sensor (1) comprises a light source (11) to generate a forward radiation (PR),
    - the current sensor (1) further comprises at least one polarization analyzer (2) according to any one of the preceding claims optically downstream of the light source (11),
    - the current sensor (1) further comprises a polarization-maintaining fiber (PM) and a sensing fiber coil (40), the sensing fiber coil (40) comprising a fiber retarder (54) and a sensing fiber, one end of the polarization-maintaining fiber (PM) is connected with a signal beam input port (21) of the polarization analyzer (2) and the other end of the polarization-maintaining fiber (PM) is connected to the fiber retarder (54) of the sensing fiber coil (40), and
    - the sensing fiber is coiled around a current conductor (3) and the sensing fiber coil (40) further comprises an end mirror (49) at an end of the sensing fiber optically remote from the fiber retarder (54).

15. A detection method using a polarization analyzer (2) according to any one of claims 1 to 13 for measuring a magneto-optic phase shift ϕ between two orthogonal polarization states of a signal radiation (SR) of a polarimetric fiber-optic current sensor (1), the method comprises:

    - receiving, by the beam splitting module (24) comprising the at least one linear polarizer (P, 42, 43) and the at least one retarder (41, 44) with the temperature-dependent retardation variation m θ(T), a signal radiation (SR), and splitting, by the beam splitting module (24), the signal radiation (SR) into at least three signal beam parts,
    - receiving, by the polarization processing module (25), the at least three signal beam parts, and processing, by the polarization processing module (25), the at least three signal beam parts so that at least three processed signal beam parts (SB1..SB4) having different intensities depending on the magneto-optic phase shift $\phi$ and on the temperature-dependent retardation m $\theta$(T) are generated,
- receiving, by the photo detector module (22) having the plurality of the detection areas (23), the at least three processed signal beam parts (SB1..SB4), and producing, by the photo detector module (22), electric signals (S1..S4) representative for intensities of the at least three processed signal beam parts (SB1..SB4), and
- receiving, by the signal processing module (26), the electric signals (S1..S4) from the photo detector module (22) and calculating the magneto-optic phase shift $\phi$ from the electric signals (S1..S4) so that a resulting magneto-optic phase shift $\phi$ is independent of the temperature-dependent retardation variation m $\theta$(T).

Fig. 1

Fig. 2

PM@45°

PR

45

55

41@0°

42

55

24

55

PM@0°

PR

SR

43

P4@45°  P3@45°  P2@90°  P1@0°

23

27

S4      S3      S2      S1

2

Fig. 3

10,1

11      42

2       24

22, 25, 26

27

PM

SB

PR

SR

ΔΦ

PM

CP

54

49

3

40

Fig. 4

Fig. 5

Fig. 6

Fig. 7

Fig. 8

25

48
62
61
47
46

Fig. 9

2

PR

55　　　　　　24　　　　　55　　PM@0°　　PR

PM@45°

41@0°　　　　　　　　　　44@0°　　　} 25

42 {
　　　P4@45° P3@45° P2@45° P1@45°

55

23　　} 22

S4　　S3　　S2　　S1

Fig. 10

2

PR

55     24     55     PM@0°     PR

PM@45°

41@0°

42 {

P4@45° P3@45° P2@45° P1@45°

} 25

55

} 22

23

S4    S3    S2    S1

Fig. 11

M1

M2

M3

Fig. 12

Europäisches
Patentamt
European
Patent Office
Office européen
des brevets

# EUROPEAN SEARCH REPORT

Application Number

EP 21 18 0013

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 010 925 A1 (ABB RESEARCH LTD [CH]) 7 January 2009 (2009-01-07) | 1,3, 13-15 | INV. G01R15/24 |
| Y | * paragraphs [0001], [0010] – [0020], | 2,9-12 | |
| A | [0027], [0039] – [0042]; figure 1 * | 4-8 | |
| | ----- | | |
| Y | US 2004/124344 A1 (RASMUSSEN JENS C [JP] ET AL) 1 July 2004 (2004-07-01) | 2,9-11 | |
| A | * paragraphs [0065], [0101] – [0114]; figures 5, 14, 17, 18, 21-22, 25-28 * | 7,8 | |
| | ----- | | |
| Y,D | US 2020/080845 A1 (YAO XIAOTIAN STEVE [US]) 12 March 2020 (2020-03-12) | 12 | |
| A | * paragraphs [0042], [0052], [0057], [0064]; figures 5, 10-11, 13-17 * | 7,8 | |
| | ----- | | |
| Y,D | US 7 372 568 B1 (YAO X STEVE [US]) 13 May 2008 (2008-05-13) * column 2, line 35 – column 3, line 15; figures 1, 2, 4 * | 11,12 | |
| | ----- | | |

**TECHNICAL FIELDS SEARCHED (IPC)**

G01R

The present search report has been drawn up for all claims

| Place of search | Date of completion of the search | Examiner |
|---|---|---|
| The Hague | 7 December 2021 | Mazagão Guerreiro, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## EP 4 105 666 A1

**ANNEX TO THE EUROPEAN SEARCH REPORT**
**ON EUROPEAN PATENT APPLICATION NO.**                    EP 21 18 0013

This annex lists the patent family members relating to the patent documents cited in the above-mentioned European search report.
The members are as contained in the European Patent Office EDP file on
The European Patent Office is in no way liable for these particulars which are merely given for the purpose of information.

07-12-2021

| Patent document cited in search report | | Publication date | Patent family member(s) | | Publication date |
|---|---|---|---|---|---|
| EP 2010925 | A1 | 07-01-2009 | CN | 101427142 A | 06-05-2009 |
| | | | EP | 2010925 A1 | 07-01-2009 |
| | | | ES | 2681269 T3 | 12-09-2018 |
| | | | US | 2009039866 A1 | 12-02-2009 |
| | | | WO | 2007121592 A1 | 01-11-2007 |
| US 2004124344 | A1 | 01-07-2004 | EP | 1421717 A1 | 26-05-2004 |
| | | | EP | 1786123 A1 | 16-05-2007 |
| | | | JP | 2005502266 A | 20-01-2005 |
| | | | US | 2004124344 A1 | 01-07-2004 |
| | | | WO | 03021822 A1 | 13-03-2003 |
| US 2020080845 | A1 | 12-03-2020 | US | 2015345950 A1 | 03-12-2015 |
| | | | US | 2018202809 A1 | 19-07-2018 |
| | | | US | 2020080845 A1 | 12-03-2020 |
| | | | WO | 2014110299 A1 | 17-07-2014 |
| US 7372568 | B1 | 13-05-2008 | NONE | | |

EPO FORM P0459

For more details about this annex : see Official Journal of the European Patent Office, No. 12/82

**EP 4 105 666 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3084450 B1
- US 20200080845 A1
- US 4904931 A
- US 7372568 B1